# EUROPEAN PATENT SPECIFICATION

(11) **EP 0 324 660 B1**
(45) Date of publication and mention of the grant of the patent: **03.06.1998**
(21) Application number: 89300371.5
(22) Date of filing: 16.01.1989
(51) Int. Cl.: H01L 39/12, H01L 39/24

(54) **Novel superconductors and processes for their preparation**
Supraleiter und Verfahren zu deren Herstellung
Supraconducteurs et procédé pour leur préparation

(30) Priority: 15.01.1988 US 144114; 12.02.1988 US 155247
(43) Date of publication of application: 19.07.1989
(73) Proprietor: UNIVERSITY OF ARKANSAS, Fayetteville, Arkansas 72701 (US)
(72) Inventor: Hermann, Allen M., Fayetteville Arkansas 72701 (US); Sheng, Zhengzhi, Fayetteville Arkansas 72701 (US)
(74) Representative: Sheard, Andrew Gregory

(56) References cited:
- EP-A- 0 316 009
- EP-A- 0 321 661
- PHYSICA B + C EUROPHYSICS JOURNAL - PROCEEDINGS OF THE YAMADA CONFERENCE XVIII ON SUPERCONDUCTIVITY IN HIGHLY CORRELATED FERMION SYSTEMS, Sendai, 31st August - 3rd September 1987, vol. 148 B + C, nos. 1-3, pages 336-338, Amsterdam, NL; Y. SAITO et al.: "High-Tc superconducting properties in (Y1-xTlx)Ba2Cu307-y, Y(Ba1-xKx)2Cu3O7-y and YBa2(Cu1-xMgx)3O7-y"
- NATURE, vol. 332, 10th March 1988, pages 138-139, Basingstoke, GB; Z.Z. Sheng et al.: "Bulk superconducivity at 120 K in the Tl-Ca/Ba-Cu-O system"
- NATURE, vol. 332, 10th March 1988, page 103, Basingstoke, GB; "Superconducting conference yields new temperature record"
- NATURE, vol. 332, 3rd March 1988, pages 55-58, Basingstoke, GB; Z.Z. SHENG et al.: "Superconductivity in the rare-earth-free Tl-Ba-Cu-O system above liquid- nitrogen temperature"

## Description

The present invention relates to high temperature superconductors and methods of their preparation.

There has been much work done recently on the development of high temperature superconductors. Recent developments have indicated that certain combinations of elements are superconducting. However, these compositions typically do not maintain their superconductive attributes at temperatures that exceed approximately 90 K. For example, recently, much work has centered on the use of ternary oxides containing rare earth elements, barium, and copper for superconductivity above the temperature of liquid nitrogen. But, these systems have limited transition temperatures, at or below 93 K, and thus their applications are limited.

U.S. Patent Application Serial Nos. 082,222, 089,067, and 144,114, filed on August 6, 1987, August 25, 1987, and January 15, 1988, respectively, in the name of the inventors of the present invention disclose superconductor systems. U.S. Patent Application Serial No. 089,067 discloses, in part, a superconductor based on a R-Ba-Cu-O wherein R is chosen from the group of rare earth metals excluding praseodymium, cerium, and terbium. U.S. Patent Application Serial No. 082,222 discloses, in part, a superconductor based on a Tb-R-Ba-Cu-O system wherein R is chosen from the group of rare earth metals excluding praseodymium, cerium, and terbium.

EP-A-0321184, which was published on 21st June 1989, refers to metal oxides of the formula A₂BₓCU_{y}O_{z} where A is an alkaline earth metal and B is Bi, Pb or Tl.

Although superconductors prepared pursuant to the systems disclosed in the above patent applications have produced "high temperature" superconductors and yielded optimistic test results, superconductors prepared pursuant to the present invention have yielded higher transition temperatures. Indeed, based on the knowledge of the inventors, superconductors produced pursuant to the present invention have yielded the highest transition temperatures to date for any superconductor.

A superconductor with a higher transition temperature would be desirable for many reasons. Such a superconductor would: (1) facilitate the discovery of the correct theory on oxide superconductivity; (2) provide a framework for the search of higher temperature, even room temperature superconductors; (3) allow superconducting components to operate at higher temperatures with lower cost; and (4) provide low cost processing and manufacturability.

Furthermore, many of the superconductor compositions that have been proposed to date are based on rare earth metals. Due to the short supply and cost of these rare earth metals, the compositions constructed therefrom can be quite expensive.

Accordingly, there is a need for improved superconductors with higher transition temperatures.

The present invention encompasses new high temperature superconductive systems and methods of making such systems. These are free of rare earth elements, may have transition temperatures above 120 K and are unique to date among high temperature superconductive systems.

Therefore, according to a first aspect of the present invention there is provided a high temperature superconductive system, which comprises a superconducting compound of the general formula:

Tl R_{y} Ba_{z} Cuᵤ Oᵥ

wherein R represents a Group 2A element, other than barium and y, z, u and v are not equal to zero Preferably, R is either strontium (Sr) or calcium (Ca).

The compounds preferably have the following approximate stoichiometry:
y is greater than zero and less than or equal to 5 (e.g. 0.3 to 0.75 inclusive);
z is greater than zero and less than or equal to 5 (e.g. 0.5 to 0.6 inclusive);
y+z is greater than or equal to 0.2 and less than or equal to 5 (e.g. 0.8 to 1.35 inclusive);
u is greater than or equal to 0.5 and less than or equal to 15 (e.g. 1.5 to 2.0 inclusive);
v is greater than or equal to z+y+u and less than or equal to 2+z+y+u (e.g. 3.25 to 4.25).

According to a second aspect of the present invention there is provided a high temperature superconductive system, comprising a superconducting compound of the general formula

Tl Sr_{y} Cuᵤ Oᵥ

wherein y, u and v are not equal to zero; excluding the compound Sr₂ Tl₃ Cu₂ Oᵥ where v is more than 4.

These compounds preferably have the following approximate stoichiometry:
y is greater than or equal to 0.2 and less than or equal to 5 (e.g. 0.45 to 1.0 inclusive);
u is greater than or equal to 0.5 and less than or equal to 15 (such as about 3.0); and
v is greater than or equal to y+u and less than or equal to 2+y+u (e.g. 3.45 to 6.0).

Compounds of the present invention may thus have high transition temperatures, and may supply the need for higher temperature superconductors, and possibly even room temperature superconductors.

The compounds of the present invention can be high temperature superconductors that are formed at relatively low temperatures, and may be produced rapidly.

Another advantage of the present invention is that it can provide superconductor compounds which may have transition temperatures above 120 K, and methods for making such compounds. The compounds do not include rare earth metals and can be used at temperatures near the boiling point of liquid nitrogen where higher critical currents are to be expected.

The present invention may thus provide new high temperature superconductor compounds and methods for their production, where the term "high temperature" refers to a temperature above the boiling point of liquid nitrogen. The present invention may also provide new superconductive compounds that may produce higher temperature, even room temperature, superconductors by further elemental substitution and variation of preparation procedures.

To date, the inventors of the present invention are not aware of any superconductors that have transition temperatures above 100 K. Of course, low transition temperatures limit the applications of the superconductors. The inventors have discovered their superconductor compounds can have transition temperatures above 120 K; which is at least 20 K higher than that of any known high temperature superconductor. Because of possible higher transition temperatures, the compounds provide superconductors that may be operated at higher temperatures with lower cost. Furthermore, the inventors of the present invention have found that the high temperature superconductor compounds of the present invention may be rapidly produced at relatively low temperatures.

According to a third aspect of the present invention there is provided a process for the preparation of a superconducting compound of the general formula:

Tl R_{y} Ba_{z} Cuᵤ Oᵥ

wherein R represents a Group 2A element other than barium, and y, z, u and v are not equal to zero;
the process comprising:
a) mixing BaCO₃ with CuO;
b) grinding the resultant mixture and heating, e.g. to obtain a uniform black BaCu₃O₄ powder, for example in air at from 900 to 950°C, preferably about 925°C e.g., for at least 24 hours;
c) mixing the resultant mixture, e.g. BaCu₃O₄ powder, with Tl₂O₃ and an oxide or carbonate of R, e.g. CaO or SrCO₃;
d) regrinding the mixture; and
e) heating the mixture in flowing oxygen.

The BaCu₃O₄ powder may be mixed with Tl₂O₃ and CaO to obtain a mixture having a nominal composition of Tl₂Ca_{1.5}BaCu₃O_{7.8+X'} Tl_{1.5}Ca_{0.5}BaCu₃O_{6.5+X}, or Tl_{1.86}CaBaCu₃O_{7.8+X}.

Suitably the mixture, after (e), is removed from the heat and quenched in air, or allowed to cool, to room temperature.

Usually the molar ratio of BaCO₃:CuO is from 1:2.5 to 1:3.5, such as about 1:3, whereas the molar ratio of BaCu₃O₄:Tl₂O₃ in (c) may be from 1:0.5 to 1:1. Such a cooled mixture may then be annealed at 450°C in flowing oxygen.

In (e) the mixture may be heated to a temperature of from 850°C or 900°C to 950°C. In a preferred embodiment of the invention, the heating step in (e) is at a temperature of from 1000-1050°C in an oxygen flow for 2 to 5 minutes. Also or as an alternative the mixture may be first pressed into a pellet before heating in flowing oxygen or in air (for example as in (b) and/or (d)).

A particularly preferred process comprises
a) mixing BaCO₃ and CuO;
b) grinding and heating the resultant mixture;
c) mixing the resultant BaCu₃O₄ powder with Tl₂O₃ and SrCO₃ and grinding the resultant mixture;
d) heating the resultant mixture in flowing oxygen to a temperature of from 900 to 950°C in flowing oxygen; and
e) cooling the heated mixture to room temperature.

According to a fourth aspect of the present invention there is provided a process for the preparation of a compound of the formula

Tl Sr_{y} Cuᵤ Oᵥ

wherein y, u and v are not equal to zero; excluding the compound Sr₂ Tl₃ Cu₂ Oᵥ, where v is more than 4;
the process comprising
a) mixing SrCO₃ and CuO;
b) grinding the resultant mixture;
c) heating the mixture, such as to obtain a uniform black Sr_{0.45}Cu₃O_{3.5} powder;
d) mixing the resultant mixture with Tl₂O₃, usually to obtain a mixture with a nominal composition of Tl₂Sr_{0.4}5Cu₃O_{6.5+X},
e) regrinding the mixture and optionally pressing into a pellet; and
f) heating the mixture, optionally in flowing oxygen.

The process preferably has the following features:
i) the mixture in c) is heated at a temperature of from 900-950°C, such as about 925°C, for at least 24 hours and/or
ii) the mixture in (f) is heated at a temperature of from 1000-1050°C, in an oxygen flow, for 2-5 minutes.

The processes of the present invention allow the compounds to be prepared at temperatures of approximately 850 to about 950°C in flowing oxygen. Accordingly, the methods of the present invention may allow the superconductor to be made at relatively low temperatures. Furthermore, the method of the present invention may allow the superconductor compounds to be produced rapidly, in approximately 30 minutes.

The invention will now be described, by way of example only, with reference to the accompanying drawings, in which:
Figure 1 illustrates a graph of electrical resistance versus temperature for three superconductor samples, the dashed line represents a prior art Eu-Ba-Cu-O superconductor and the solid line and line represented by "O" depict compounds in accordance with the present invention based on a Tl-Ca-Ba-Cu-O superconductor system; and
Figure 2 illustrates a graph of electrical resistance versus temperature for two superconductor samples in accordance with the present invention, where "●" represents a superconductor based on TlSrCuO, and " 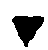 " represents a superconductor based on TlSrBaCuO.

In some of the Examples use is made of the symbol X in the stoichiometric amounts of oxygen in certain compounds. It is to be understood that the range of values of X is such that the stoichiometric amount of oxygen falls within the limits prescribed for the present invention.

### EXAMPLE 1

A. The following reagents were utilized:
1. Tl₂O₃,
2. CaO,
3. BaCO₃,
4. CuO.

B. The following procedure was followed using the above reagents to create a superconductor:
1. A mixture of a one molar portion of BaCO₃ and a three molar portion of CuO was ground with an agate mortar and pestle. The ground mixture was heated in air at approximately 925°C for more than 24 hours (with several intermediate grindings) to obtain a uniform black BaCu₃O₄ powder.
2. The resultant BaCu₃O₄ powder was mixed with appropriate amounts of Tl₂O₃ and CaO to obtain a mixture with a nominal composition of Tl_{1.86}CaBaCu₃O_{7.8+X}, which was completely ground, and pressed into a pellet.
3. A tube furnace was heated to a temperature of between approximately 850 to 950°C with oxygen flowing therein.
4. The pellet was placed in the tube furnace maintaining the temperature and oxygen flow for approximately 2 to 5 minutes.
5. The pellet was then taken out of the furnace and quenched in air to room temperature.

The samples prepared by this procedure had an onset temperature of above 120 K, a midpoint of about 110 K, and a zero resistance temperature of about 100 K. Qualitative magnetic examinations of the superconductor of this example demonstrate a strong Meissner effect, indicating a large volume fraction of superconducting phase.

### COMPARATIVE EXAMPLE 1

A. In this example, the following reagents were utilized:
1. Tl₂O₃,
2. CaO,
3. BaCO₃,
4. CuO.

B. To produce a superconductor with these reagents, the following procedure was followed:
1. A mixture of a one molar portion of BaCO₃ and a three molar portion of CuO was ground with an agate mortar and pestle, heated in air at approximately 925°C for more than 24 hours (with several intermediate grindings) to obtain a uniform black BaCu₃O₄ powder.
2. The resulting BaCu₃O₄ powder was mixed with appropriate amounts of Tl₂O₃ and CaO to obtain a mixture with a nominal composition of Tl_{1.86}CaBaCu₃O_{7.8+X}, which was completely ground, and pressed into a pellet.
3. A tube furnace was heated to a temperature of between approximately 850 to 950°C with oxygen flowing therein.
4. The pellet was placed in the tube furnace maintaining the temperature and oxygen flow for approximately 2 to 5 minutes.
5. The pellet was then taken out of the furnace and quenched in air to room temperature.
6. The pellet was then annealed at approximately 450°C in flowing oxygen for 6 hours.

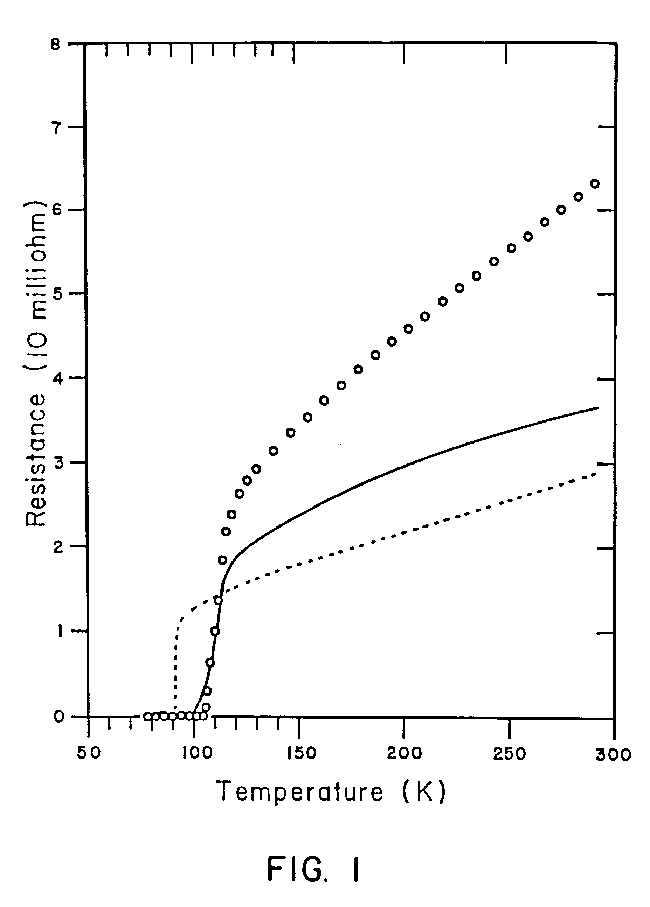

The samples prepared by this procedure had an onset temperature of above 120 K, a midpoint of about 110 K, and a zero resistance temperature of about 100 K. The sample is indicated by a solid line in Figure 1 illustrating resistance-temperature dependence. Qualitative magnetic examinations of the samples demonstrated a strong Meissner effect, indicating a large volume fraction of superconducting phase. This can be compared with a prior art Eu-Ba-Cu-O superconductor depicted in Figure 1 by a dashed line.

### EXAMPLE 2

A. The following reagents were utilized:
1. Tl₂O₃,
2. CaO,
3. BaCO₃,
4. CuO.

B. The following procedure was followed:
1. A mixture of a one molar portion of BaCO₃ and a three molar portion of CuO was ground with an agate mortar and pestle, heated in air at 925°C for more than 24 hours (with several intermediate grindings) to obtain a uniform black BaCu₃O₄ powder.
2. The resulting BaCu₃O₄ powder was mixed with appropriate amounts of Tl₂O₃ and CaO to obtain a mixture with a nominal composition of Tl₂Ca_{1.5}BaCu₃O_{8.5+X}, which was completely ground, and pressed into a pellet.
3. A tube furnace was heated to a temperature of approximately 850 to 950°C with oxygen flowing therein.
4. The pellet was placed in the tube furnace maintaining the temperature and oxygen flow for approximately 2 to 5 minutes.
5. The pellet was then taken out of the furnace and quenched in air to room temperature.

The samples prepared by this procedure had an onset temperature of above 123 K, a midpoint of about 112 K, and a zero resistance temperature of about 103 K. Qualitative magnetic examinations of the samples showed a strong Meissner effect, indicating a large volume fraction of superconducting phase.

### EXAMPLE 3

A. The following reagents were utilized in this example:
1. Tl₂O₃,
2. CaO,
3. BaCO₃,
4. CuO.

B. The following procedure was followed in this example:
1. A mixture of a one molar portion of BaCO₃ and a three molar portion of CuO was ground with an agate mortar and pestle, heated in air at 925°C for more than 24 hours (with several intermediate grindings) to obtain a uniform black BaCu₃O₄ powder.
2. The resulting BaCu₃O₄ powder was mixed with appropriate amounts of Tl₂O₃ and CaO to obtain a mixture with a nominal composition of Tl₂Ca_{1.5}BaCu₃O_{8.5+X}, which was completely ground, and pressed into a pellet.
3. A tube furnace was heated to a temperature of between approximately 850 to 950°C with oxygen flowing therein.
4. The pellet was placed in the tube furnace maintaining the temperature and oxygen flow for approximately 2 to 5 minutes.
5. The pellet was then furnace-cooled to room temperature.

The samples prepared by this procedure had an onset temperature of above 123 K, a midpoint of about 112 K, and a zero resistance temperature of about 103 K. The sample is indicated by the line defined by "O" in Figure 1 illustrating resistance-temperature dependence for this example. Qualitative magnetic examinations of this sample demonstrated a strong Meissner effect, indicating a large volume fraction of superconducting phase.

### EXAMPLE 4

A. In this example, the following reagents were utilized:
1. Tl₂O₃,
2. CaO,
3. BaCO₃,
4. CuO.

B. In this example, the following procedure was followed:
1. A mixture of a one molar portion of BaCO₃ and a three molar portion of CuO was ground with an agate mortar and pestle, heated in air at 925°C for more than 24 hours (with several intermediate grindings) to obtain a uniform black BaCu₃O₄ powder.
2. The resulting BaCu₃O₄ powder was mixed with appropriate amounts of Tl₂O₃ and CaO to obtain a mixture with a nominal composition of Tl_{1.5}Ca_{0.5}BaCu₃O_{6.8+X}, which was completely ground, and pressed into a pellet.
3. A tube furnace was heated to a temperature of approximately 850 to 950°C with oxygen flowing therein.
4. The pellet was placed in the tube furnace maintaining the temperature and oxygen flow for approximately 2 to 5 minutes.
5. The pellet was then taken out of the furnace and quenched in air to room temperature.

The sample prepared by this procedure had an onset temperature of about 120 K, a midpoint of about 110 K, and a zero resistance temperature of above liquid nitrogen temperature.

### EXAMPLE 5

A. The following reagents were utilized in this example:
1. Tl₂O₃,
2. SrCO₃,
3. CuO.

B. The following procedure was followed in this example:
1. A mixture of a 0.45 molar portion of SrCO₃ and a three molar portion of CuO was ground with an agate mortar and pestle, heated in air at 925°C for more than 24 hours (with several intermediate grindings) to obtain a uniform black Sr_{0.45}Cu₃O_{3.5} powder.
2. The resulting Sr_{0.45}Cu₃O_{3.5} powder was mixed with an appropriate amount of Tl₂O₃ to obtain a mixture with a nominal composition of Tl₂Sr_{0.45}Cu₃O_{6.5+X}, which was completely ground, and pressed into a pellet.
3. A tube furnace was heated to a temperature of between approximately 1000 to 1050°C with oxygen flowing therein.
4. The pellet was placed in the tube furnace maintaining the temperature and oxygen flow for approximately 2 to 5 minutes.
5. The pellet was then taken out of the furnace and quenched in air to room temperature.

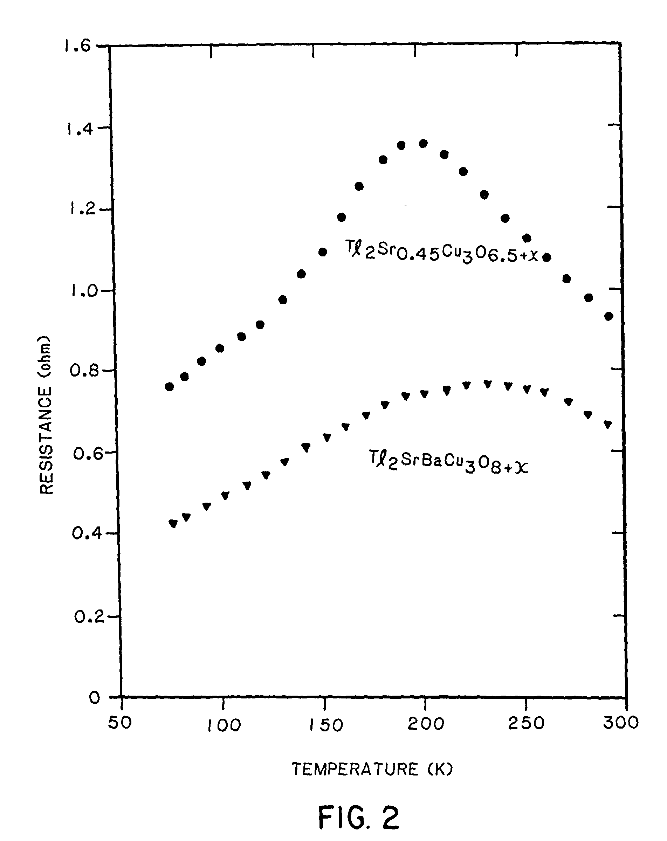

Resistance-temperature dependence for a sample prepared pursuant to this example is illustrated in Figure 2 as represented by the "●" line. Although resistance did not reach zero above liquid nitrogen temperature, it may reach zero at lower temperatures. In particular, a decrease in the resistance at about 200 K may originate from the onset of a high temperature superconducting phase of the sample.

### EXAMPLE 6

A. In this example, the following reagents were utilized:
1. Tl₂O₃,
2. SrCO₃,
3. BaCO₃,
4. CuO.

B. In this example, the following procedure was followed:
1. A mixture of a one molar portion of BaCO₃ and a three molar portion of CuO was ground with an agate mortar and pestle, heated in air at 925°C for more than 24 hours (with several intermediate grindings) to obtain a uniform black BaCu₃O₄ powder.
2. The resulting BaCu₃O₄ powder was mixed with appropriate amounts of Tl₂O₃ and SrCO₃ to obtain a mixture with a nominal composition of Tl₂SrBaCu₃O_{8+X}, which was completely ground, and pressed into a pellet.
3. A tube furnace was heated to a temperature of between approximately 900 to about 950°C with oxygen flowing thereinf.
4. The pellet was placed in the tube furnace maintaining the temperature and oxygen flow for approximately 2 to 5 minutes.
5. The pellet was then taken out of the furnace and quenched in air to room temperature.

Resistance-temperature dependence for the sample prepared pursuant to this example is illustrated in Figure 2 as the " 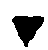 " line. Although the resistance did not reach zero above liquid nitrogen temperature, it may reach zero at lower temperatures. In particular, a decrease in resistance at about 250 K may originate from onset of a high temperature superconducting phase of the sample.

## Claims (Claims for the following Contracting State(s): AT, BE, CH, DE, FR, GB, GR, LI, LU, IT, NL, SE)

1. A superconducting compound of the general formula:
Tl R_{y} Ba_{z} Cuᵤ Oᵥ
wherein:
R represents a Group 2A element other than barium, and y, z, u and v are not equal to zero.

2. A compound as claimed in Claim 1 wherein R represents strontium or calcium.

3. A compound as claimed in Claim 2
wherein:
y has a value greater than zero and less than or equal to 5;
z has a value greater than zero and less than or equal to 5;
y+z has a value greater than or equal to 0.2 and less than or equal to 5;
u has a value greater than or equal to 0.5 and less than or equal to 15; and
v has a value greater than or equal to z+y+u and less than or equal to 2+z+y+u.

4. A superconducting compound of the general formula:
Tl Sr_{y} Cuᵤ Oᵥ
wherein y, u and v are not equal to zero, excluding the compound Sr₂ Tl₃ Cu₂ Oᵥ where v is more than 4.

5. A compound as claimed in Claim 4 wherein:
y is greater than or equal to 0.2 and less than or equal to 5;
u is greater than or equal to 0.5 and less than or equal to 15;
v is greater than or equal to y+u and less than or equal to 2+y+u.

6. A process for the preparation of a superconducting compound of the general formula:
Tl R_{y} Ba_{z} Cuᵤ Oᵥ
wherein:
R represents a Group 2A element other than barium and y, z, u and v are not equal to zero;
the process comprising:
a) mixing BaCO₃ with CuO;
b) grinding the resultant mixture and heating;
c) mixing the resultant mixture with Tl₂O₃ and a carbonate or oxide of R;
d) regrinding the mixture; and
e) heating the mixture in flowing oxygen.

7. A process as claimed in Claim 6 wherein the carbonate or oxide of R is CaO or SrCO₃.

8. A process as claimed in Claim 6 or 7 wherein
i) the heating step in (b) is at a temperature of from 900 to 950°C for at least 24 hours, and/or
ii) the heating step in (e) is at a temperature of from 1000-1050°C in an oxygen flow for 2 to 5 minutes.

9. A process for the preparation of a superconducting compound of the general formula:
Tl Sr_{y} Cuᵤ Oᵥ
wherein y, u and v are not equal to zero; excluding the compound Sr₂Tl₃Cu₂Oᵥ where v is more than 4;
the process comprising:
a) mixing SrCO₃ and CuO;
b) grinding the resultant mixture;
c) heating the mixture;
d) mixing the resultant mixture with Tl₂O₃;
e) regrinding the mixture and optionally pressing into a pellet;
f) heating the mixture, optionally in flowing oxygen.

10. A process as claimed in Claim 9 wherein:
i) the mixture in (c) is heated at a temperature of from 900-950°C for at least 24 hours, and/or
ii) the mixture in (f) is heated at a temperature of from 1000-1050°C in flowing oxygen for 2-5 minutes.

## Claims (Claims for the following Contracting State(s): ES)

1. A superconducting compound of the general formula:
Tl R_{y} Ba_{z} Cuᵤ Oᵥ
wherein:
R represents a Group 2A element other than barium, and y, z, u and v are not equal to zero.

2. A compound as claimed in Claim 1 wherein R represents strontium or calcium.

3. A compound as claimed in Claim 2 wherein:
y has a value greater than zero and less than or equal to 5;
z has a value greater than zero and less than or equal to 5;
y+z has a value greater than or equal to 0.2 and less than or equal to 5;
u has a value greater than or equal to 0.5 and less than or equal to 15; and
v has a value greater than or equal to z+y+u and less than or equal to 2+z+y+u.

4. A superconducting compound of the general formula:
Tl Sr_{y} Cuᵤ Oᵥ
wherein y, u and v are not equal to zero; excluding the compound Sr₂Tl₃Cu₂Oᵥ where v is more than 4.

5. A compound as claimed in Claim 4 wherein:
y is greater than or equal to 0.2 and less than or equal to 5;
u is greater than or equal to 0.5 and less than or equal to 15;
v is greater than or equal to y+u and less than or equal to 2+y+u.

6. A process for the preparation of a superconducting compound of the general formula:
Tl R_{y} Ba_{z} Cuᵤ Oᵥ
wherein:
R represents a Group 2A element other than barium, and y, z, u and v are not equal to zero;
the process comprising:
a) mixing BaCO₃ with CuO;
b) grinding the resultant mixture and heating;
c) mixing the resultant mixture with Tl₂O₃ and a carbonate or oxide of R;
d) regrinding the mixture;
e) heating the mixture in flowing oxygen.

7. A process as claimed in Claim 6 wherein the oxide or carbonate of R is CaO or SrCO₃.

8. A process as claimed in Claim 6 or 7 wherein
i) the heating step in (b) is at a temperature of from 900 to 950°C for at least 24 hours, and/or
ii) the heating step in (e) is at a temperature of from 1000-1050°C in an oxygen flow for 2 to 5 minutes.

9. A process as claimed in any of Claims 6 to 8 wherein the molar ratio of BaCO₃:CuO is from 1:2.5 to 1:3.5.

10. A process as claimed in Claim 9 wherein the molar ratio of BaCu₃O₄:Tl₂O₃ in (c) is from 1:0.5 to 1:1.

11. A process as claimed in any of Claims 6 to 10 wherein the mixture is compressed into a pellet in (b) and/or (d).

12. A process as claimed in any of Claims 6 to 11 wherein the mixture after (e) is removed from the heat and quenched in air to room temperature.

13. A process as claimed in any of Claims 6 to 12 wherein in (b) the mixture is heated in air.

14. A process for the preparation of a superconducting compound of the general formula:
Tl Sr_{y} Cuᵤ Oᵥ
wherein y, u and v are not equal to zero; excluding the compound Sr₂Tl₃Cu₂Oᵥ where v is more than 4;
the process comprising:
a) mixing SrCO₃ and CuO;
b) grinding the resultant mixture;
c) heating the mixture;
d) mixing the resultant mixture with Tl₂O₃;
e) regrinding the mixture and optionally pressing into a pellet;
f) heating the mixture, optionally in flowing oxygen.

15. A process as claimed in Claim 14 wherein:
i) the mixture in (c) is heated at a temperature of from 900-950°C for at least 24 hours, and/or
ii) the mixture in (f) is heated at a temperature of from 1000-1050°C in flowing oxygen for 2-5 minutes.

## Patentansprüche (Patentansprüche für folgende(n) Vertragsstaat(en): AT, BE, CH, DE, FR, GB, GR, LI, LU, IT, NL, SE)

1. Supraleitende Verbindung der allgemeinen Formel:
Tl R_{y} Ba_{z} Cuᵤ Oᵥ
wobei:
R ein Element der Gruppe 2A, das nicht Barium ist, darstellt, und y, z, u und v nicht gleich Null sind.

2. Verbindung nach Anspruch 1, wobei R Strontium oder Kalzium darstellt.

3. Verbindung nach Anspruch 2, wobei:
y einen Wert größer Null und kleiner oder gleich 5 hat;
z einen Wert größer Null und kleiner oder gleich 5 hat;
y+z einen Wert größer oder gleich 0,2 und kleiner oder gleich 5 hat;
u einen Wert größer oder gleich 0,5 und kleiner oder gleich 15 hat; und
v einen Wert größer oder gleich z+y+u und kleiner oder gleich 2+z+y+u hat.

4. Supraleitende Verbindung der allgemeinen Formel:
Tl Sr_{y} Cuᵤ Oᵥ
wobei:
y, u und v nicht gleich Null sind, ausgenommen die Verbindung Sr₂Tl₃Cu₂Oᵥ, wenn v größer als 4 ist.

5. Verbindung nach Anspruch 4, wobei:
y größer oder gleich 0,2 und kleiner oder gleich 5 ist;
u größer oder gleich 0,5 und kleiner oder gleich 15 ist;
v größer oder gleich y+u und kleiner oder gleich 2+y+u ist.

6. Verfahren zur Herstellung einer supraleitenden Verbindung der allgemeinen Formel:
Tl R_{y} Ba_{z} Cuᵤ Oᵥ
wobei:
R ein Element der Gruppe 2A, das nicht Barium ist, darstellt, und y, z, u und v nicht gleich Null sind;
wobei das Verfahren folgendes umfaßt:
a) Mischen von BaCO₃ mit CuO;
b) Mahlen der erhaltenen Mischung und Erwärmen;
c) Mischen der erhaltenen Mischung mit Tl₂O₃ und einem Karbonat oder Oxid von R;
d) neuerliches Mahlen der Mischung; und
e) Erwärmen der Mischung in strömendem Sauerstoff.

7. Verfahren nach Anspruch 6, wobei das Karbonat oder Oxid von R CaO oder SrCO₃ ist.

8. Verfahren nach Anspruch 6 oder 7, wobei
i) der Erwärmungsschritt in (b) bei einer Temperatur von 900 bis 950°C über mindestens 24 Stunden ausgeführt wird und/oder
ii) der Erwärmungsschritt in (e) bei einer Temperatur von 1000-1050°C in einem Sauerstoffstrom über 2 bis 5 Minuten ausgeführt wird.

9. Verfahren zur Herstellung einer supraleitenden Verbindung der allgemeinen Formel:
Tl Sr_{y} Cuᵤ Oᵥ
wobei y, u und v nicht gleich Null sind; ausgenommen die Verbindung Sr₂Tl₃Cu₂Oᵥ, wenn v größer als 4 ist;
wobei das Verfahren folgendes umfaßt:
a) Mischen von SrCO₃ und CuO;
b) Mahlen der erhaltenen Mischung;
c) Erwärmen der Mischung;
c) Mischen der erhaltenen Mischung mit Tl₂O₃;
d) neuerliches Mahlen der Mischung und wahlweise Pressen zu einem Pellet;
e) Erwärmen der Mischung, wahlweise in strömendem Sauerstoff.

10. Verfahren nach Anspruch 9, wobei:
i) die Mischung in (c) bei einer Temperatur von 900 bis 950°C über mindestens 24 Stunden erwärmt wird und/oder
ii) die Mischung in (f) bei einer Temperatur von 1000-1050°C in strömendem Sauerstoff 2 bis 5 Minuten erwärmt wird.

## Patentansprüche (Patentansprüche für folgende(n) Vertragsstaat(en): ES)

1. Supraleitende Verbindung der allgemeinen Formel:
Tl R_{y} Ba_{z} Cuᵤ Oᵥ
wobei:
R ein Element der Gruppe 2A, das nicht Barium ist, darstellt, und y, z, u und v nicht gleich Null sind.

2. Verbindung nach Anspruch 1, wobei R Strontium oder Kalzium darstellt.

3. Verbindung nach Anspruch 2, wobei:
y einen Wert größer Null und kleiner oder gleich 5 hat;
z einen Wert größer Null und kleiner oder gleich 5 hat;
y+z einen Wert größer oder gleich 0,2 und kleiner oder gleich 5 hat;
u einen Wert größer oder gleich 0,5 und kleiner oder gleich 15 hat; und
v einen Wert größer oder gleich z+y+u und kleiner oder gleich 2+z+y+u hat.

4. Supraleitende Verbindung der allgemeinen Formel:
Tl Sr_{y} Cuᵤ Oᵥ
wobei y, u und v nicht gleich Null sind; ausgenommen die Verbindung Sr₂Tl₃Cu₂Oᵥ, wenn v größer als 4 ist.

5. Verbindung nach Anspruch 4, wobei:
y größer oder gleich 0,2 und kleiner oder gleich 5 ist;
u größer oder gleich 0,5 und kleiner oder gleich 15 ist;
v größer oder gleich y+u und kleiner oder gleich 2+y+u ist.

6. Verfahren zur Herstellung einer supraleitenden Verbindung der allgemeinen Formel:
Tl R_{y} Ba_{z} Cuᵤ Oᵥ
wobei:
R ein Element der Gruppe 2A, das nicht Barium ist, darstellt, und y, z, u und v nicht gleich Null sind;
wobei das Verfahren folgendes umfaßt:
a) Mischen von BaCO₃ mit CuO;
b) Mahlen der erhaltenen Mischung und Erwärmen;
c) Mischen der erhaltenen Mischung mit Tl₂O₃ und einem Karbonat oder Oxid von R;
d) neuerliches Mahlen der Mischung;
e) Erwärmen der Mischung in strömendem Sauerstoff.

7. Verfahren nach Anspruch 6, wobei das Oxid oder Karbonat von R CiO oder SrCO₃ ist.

8. Verfahren nach Anspruch 6 oder 7, wobei
i) der Erwärmungsschritt in (b) bei einer Temperatur von 900 bis 950°C über mindestens 24 Stunden ausgeführt wird und/oder
ii) der Erwärmungsschritt in (e) bei einer Temperatur von 1000-1050°C in einem Sauerstoffstrom über 2 bis 5 Minuten ausgeführt wird.

9. Verfahren nach einem der Ansprüche 6 bis 8, wobei das Molverhältnis von BaCO₃:CuO von 1:2,5 bis 1:3,5 beträgt.

10. Verfahren nach Anspruch 9, wobei das Molverhältnis von BaCu₃O₄:Tl₂O₃ in (c) 1:0,5 bis 1:1 beträgt.

11. Verfahren nach einem der Ansprüche 6 bis 10, wobei die Mischung in (b) und/oder (d) zu einem Pellet gepreßt wird.

12. Verfahren nach einem der Ansprüche 6 bis 11, wobei die Mischung nach (e) aus der Wärme entfernt und in Luft auf Raumtemperatur abgeschreckt wird.

13. Verfahren nach einem der Ansprüche 6 bis 12, wobei in (b) die Mischung in Luft erwärmt wird.

14. Verfahren zur Herstellung einer supraleitenden Verbindung der allgemeinen Formel:
Tl Sr_{y} Cuᵤ Oᵥ
wobei y, u und v nicht gleich Null sind; ausgenommen die Verbindung Sr₂Tl₃Cu₂Oᵥ, wenn v größer als 4 ist;
wobei das Verfahren folgendes umfaßt:
a) Mischen von SrCO₃ und CuO;
b) Mahlen der erhaltenen Mischung;
c) Erwärmen der Mischung;
d) Mischen der erhaltenen Mischung mit Tl₂O₃;
e) neuerliches Mahlen der Mischung und wahlweises Pressen zu einem Pellet;
f) Erwärmen der Mischung, wahlweise in strömendem Sauerstoff.

15. Verfahren nach Anspruch 14, wobei:
i) die Mischung in (c) bei einer Temperatur von 900 bis 950°C über mindestens 24 Stunden erwärmt wird und/oder
ii) die Mischung in (f) bei einer Temperatur von 1000-1050°C in strömendem Sauerstoff 2 bis 5 Minuten erwärmt wird.

## Revendications (Revendications pour l'(les) Etat(s) contractant(s) suivant(s): AT, BE, CH, DE, FR, GB, GR, LI, LU, IT, NL, SE)

1. Composé supraconducteur de formule générale:
TlR_{y}Ba_{z}CuᵤOᵥ
dans laquelle R représente un élément du groupe 2A autre que le baryum, et y, z, u, et v ne sont pas égaux à zéro.

2. Composé selon la revendication 1, dans lequel R représente le strontium ou le calcium.

3. Composé selon la revendication 2, dans lequel
y a une valeur supérieure à zéro et inférieure ou égale à 5;
z a une valeur supérieure à zéro et inférieure ou égale à 5;
y + z a une valeur supérieure ou égale à 0,2 et inférieure ou égale à 5;
u a une valeur supérieure ou égale à 0,5 et inférieure ou égale à 15; et
v a une valeur supérieure ou égale à z + y + u et inférieure ou égale à 2 + z + y + u.

4. Composé supraconducteur de formule générale:
TlSr_{y}CuᵤOᵥ
dans laquelle y, u et v ne sont pas égaux à zéro; à l'exclusion du composé Sr₂Tl₃Cu₂Oᵥ où v est supérieur à 4.

5. Composé selon la revendication 4 dans lequel:
y est supérieur ou égal à 0,2 et inférieur ou égal à 5;
u est supérieur ou égal à 0,5 et inférieur ou égal à 15;
v est supérieur ou égal à y + u et inférieur ou égal 2 + y + u.

6. Procédé de préparation d'un composé supraconducteur de formule générale
TlR_{y}Ba_{z}CuᵤOᵥ
dans laquelle R représente un élément du groupe 2A autre que le baryum, et z, y, u et v ne sont pas égaux à zéro;
le procédé comprenant:
a) le mélange de BaCO₃ avec CuO;
b) le broyage du mélange résultant et le chauffage;
c) le mélange du mélange résultant avec Tl₂O₃ et un carbonate ou un oxyde de R;
d) le rebroyage du mélange; et
e) le chauffage du mélange dans un courant d'oxygène.

7. Procédé selon la revendication 6, dans lequel l'oxyde ou le carbonate de R est CaO ou SrCO₃.

8. Procédé selon la revendication 6 ou 7, dans lequel
i) l'étape de chauffage en (b) est à une température de 900 à 950°C pendant au moins 24 heures; et/ou
ii) l'étape de chauffage en (e) est à une température de 1000-1050°C dans un courant d'oxygène pendant 2 à 5 minutes.

9. Procédé pour la préparation d'un composé supraconducteur de formule générale:
TlSr_{y}CuᵤOᵥ
dans laquelle y, u et v ne sont pas égaux à zéro; à l'exclusion du composé Sr₂Tl₃Cu₂Oᵥ où v est supérieur à 4;
le procédé comprenant:
a) le mélange de SrCO₃ et de CuO;
b) le broyage du mélange résultant;
c) le chauffage du mélange;
d) le mélange du mélange résultant avec Tl₂O₃;
e) le rebroyage du mélange et facultativement le pressage en une pastille;
f) le chauffage du mélange, facultativement dans un courant d'oxygène.

10. Procédé selon la revendication 9, dans lequel:
i) le mélange en (c) est chauffé à une température de 900-950°C pendant au moins 24 heures; et/ou
ii) le mélange en (f) est chauffé à une température de 1000-1050°C dans un courant d'oxygène pendant 2 à 5 minutes.

## Revendications (Revendications pour l'(les) Etat(s) contractant(s) suivant(s): ES)

1. Composé supraconducteur de formule générale:
TlR_{y}Ba_{z}CuᵤOᵥ
dans laquelle R représente un élément du groupe 2A autre que le baryum, et y, z, u, et v ne sont pas égaux à zéro.

2. Composé selon la revendication 1, dans lequel R représente le strontium ou le calcium.

3. Composé selon la revendication 2, dans lequel
y a une valeur supérieure à zéro et inférieure ou égale à 5;
z a une valeur supérieure à zéro et inférieure ou égale à 5;
y + z a une valeur supérieure ou égale à 0,2 et inférieure ou égale à 5;
u a une valeur supérieure ou égale à 0,5 et inférieure ou égale à 15; et
v a une valeur supérieure ou égale à z + y + u et inférieure ou égale à 2 + z + y + u.

4. Composé supraconducteur de formule générale:
TlSr_{y}CuᵤOᵥ
dans laquelle y, u et v ne sont pas égaux à zéro; à l'exclusion du composé Sr₂Tl₃Cu₂Oᵥ où v est supérieur à 4.

5. Composé selon la revendication 4, dans lequel:
y est supérieur ou égal à 0,2 et inférieur ou égal à 5;
u est supérieur ou égal à 0,5 et inférieur ou égal à 15;
v est supérieur ou égal à y + u et inférieur ou égal 2 + y + u.

6. Procédé pour la préparation d'un composé supraconducteur de formule générale :
TlR_{y}Ba_{z}CuᵤOᵥ
dans laquelle R représente un élément du groupe 2A autre que le baryum, et z, y, u et v ne sont pas égaux à zéro;
le procédé comprenant:
a) le mélange de BaCO₃ avec CuO;
b) le broyage du mélange résultant et le chauffage;
c) le mélange du mélange résultant avec Tl₂O₃ et un carbonate ou un oxyde de R;
d) le rebroyage du mélange; et
e) le chauffage du mélange dans un courant d'oxygène.

7. Procédé selon la revendication 6, dans lequel l'oxyde ou le carbonate de R est CaO ou SrCO₃.

8. Procédé selon la revendication 6 ou 7, dans lequel
i) l'étape de chauffage en (b) est à une température de 900 à 950°C pendant au moins 24 heures; et/ou
ii) l'étape de chauffage en (e) est à une température de 1000-1050°C dans un courant d'oxygène pendant 2 à 5 minutes.

9. Procédé selon l'une quelconque des revendications 6 à 8, dans lequel le rapport molaire de BaCO₃:CuO est de 1:2,5 à 1:3,5.

10. Procédé selon la revendication 9, dans lequel le rapport molaire de BaCO₃:Tl₂O₃ en (c) est de 1:0,5 à 1:1.

11. Procédé selon l'une quelconque des revendications 6 à 10, dans lequel le mélange est compressé en une pastille en (b) et/ou en (d).

12. Procédé selon l'une quelconque des revendications 6 à 11, dans lequel le mélange après (e) est retiré de la chaleur et refroidi à l'air jusqu'à température ambiante.

13. Procédé selon l'une quelconque des revendications 6 à 12, dans lequel, en (b), le mélange est chauffé à l'air.

14. Procédé pour la préparation d'un composé supraconducteur de formule générale:
TlSr_{y}CuᵤOᵥ
dans laquelle y, u et v ne sont pas égaux à zéro; à l'exclusion du composé Sr₂Tl₃Cu₂Oᵥ où v est supérieur à 4;
le procédé comprenant:
a) le mélange de SrCO₃ et de CuO;
b) le broyage du mélange résultant;
c) le chauffage du mélange;
d) le mélange du mélange résultant avec Tl₂O₃;
e) le rebroyage du mélange et facultativement, le pressage en une pastille;
f) le chauffage du mélange, facultativement dans un courant d'oxygène.

15. Procédé selon la revendication 14, dans lequel:
i) le mélange en (c) est chauffé à une température de 900-950°C pendant au moins 24 heures; et/ou
ii) le mélange en (f) est chauffé à une température de 1000-1050°C dans un courant d'oxygène pendant 2 à 5 minutes.
